# EUROPEAN PATENT SPECIFICATION

(11) **EP 0 799 904 B1**
(45) Date of publication and mention of the grant of the patent: **20.09.2000**
(21) Application number: 97105545.4
(22) Date of filing: 03.04.1997
(51) Int. Cl.: C23C 14/30, C23C 14/06, C23C 14/02

(54) **Method of producing a graded coating with a top ceramic layer**
Verfahren zur Herstellung einer Gradientenschicht mit einer keramischen Deckschicht
Procédé de production d'une couche à gradient avec un revêtement supérieur de type céramique

(30) Priority: 04.04.1996 UA 96041326
(43) Date of publication of application: 08.10.1997
(73) Proprietor: International Center for Electron Beam Technologies of E.O. Paton Electric Welding Institute, Kiev 252005 (UA)
(72) Inventor: Movchan, Boris A., Kiev 252004 (UA); Rudoy, Jury E., Kiev 252167 (UA); Malashenko Igor S., Kiev 252004 (UA)
(74) Representative: Sparing - Röhl - Henseler Patentanwälte

(56) References cited:
- US-A- 4 248 940
- US-A- 4 676 994
- US-A- 5 296 274
- IEEE TRANSACTIONS ON PARTS MATERIALS AND PACKAGING, vol. 3, no. 4, December 1967, pages 154-161, XP002034648 G.C.RIDDLE: "EVAPORATED CERMET MATERIALS"
- 3RD INTERNATIONAL SAMPE METALS AND METALS PROCESSING CONFERENCE. VOL.3. ADVANCEMENTS IN SYNTHESIS AND PROCESSES, AND 24TH INTERNATIONAL SAMPE TECHNICAL CONFERENCE. VOL.24. ADVANCED MATERIALS: MEETING THE ECONOMIC CHALLENGE, TORONTO, ONT., CANADA, 20-, ISBN 0-938994-66-2, 1992, COVINA, CA, USA, SOC. ADV. MATER. PROCESS ENG, USA, pages M266-M277, XP002034649 LANG R V ET AL: "Development of compositionally graded thermal barrier coatings using ion assisted electron beam co-evaporation"

## Description

The present invention relates to the field of high temperature material production used as oxidation and gas corrosion protection as well as protective coatings for thermal loaded components of gas turbines and internal combustion engines. In particular, the invention relates to the field of electron beam technology of production on a substrate of protective coatings with chemical composition and structure gradient across the thickness (functionally gradient coatings - FG Coats) with top ceramic layer by means of evaporation and condensation of metals/alloys and chemical compounds (oxides) having different melting temperature and vapor pressure in vacuum.

Functionally gradient coats are characterized by a continuous (smooth) or discrete (laminated) change of chemical composition and structure across the thickness of protective layer. Variation gradient of chemical composition and structure can be obtained by different technological processes.

A well-known example of the method for protective coating production (with chemical and phase composition gradient across the thickness of protective layer) is a diffusion method for coating production using chemical-thermal treatment [Yu.A.Tamarin, Oxidation-resistant diffusion coatings for GTE blades.-M., Mashinostoenie, 1978, 134 pg.] Due to the production method itself, the main drawback of similar protective coatings is low thermal stability of the protective layer under high temperature conditions. These coatings cannot also provide thermal protection of gas turbine blades.

Other methods for protective coating production are air plasma spray technology (APS), vacuum-plasma spray (VPS, LPPS) and electron beam physical vapor deposition (EB-PVD) on the protecting substrate. These coats relate to the overlay or independent class of coatings.

An application of several plasmatrons is known [Application PCT/US93/05005 dated 26.05.93 (published on dated 9.12.1993, WO 093/24676)] for thermal barrier and wear-resistant coating deposition when they are formed by means of a program variation of plasmatron operating modes controlled by a computer. As a result a variable concentration of the hardening phase MeX (where X is oxygen) is reached across the deposited layer thickness from 0% at the substrate to 60-80-100% optimal value on the external surface of the coating. This method requires considerable power resources, is rather labor-consuming, but its main drawback is the difficulty to stabilize plasmatron operation modes for precise reproduction of the composition and structure required gradient across the thickness of protective coat.

A production method of a thick (δ ≤ 2 mm) gradient coating consisting of separate microlayers (δ ≈ 70 µm) of variable composition with a flat interface between the layers using a single plasmatron with two separate feeders is described in [S. Sampath et al. Thermal spray processing of FGMs/MRS Bulletin. - 1995, 20, 1, p. 27-29]. Here an example of plasmatron operation computer software is given while NiCr-(ZrO₂-8%Y₂O₃) gradient coating is deposited having 100% ceramics on the protective layer surface. Summary thickness of the coat reaches 800 µm. However, such coatings have short life time, as the flat interface between separate microlayers creates favorable conditions for the microcrack formation in these interfaces, for their growth and as a result the coating material being laminated and failed during thermal cycling.

To increase durability of thermal barrier coatings with δ ≤ 250 µm thickness produced by air plasma spray (APS) the bond coat surface, for example, Ni-10Co-18Cr-6.5Al-0.3Y is subjected to additional aluminizing to obtain in the external layer a β-(Ni,Co)Al type intermetallic structure with aluminium gradient across the thickness, while Al content on the surface reaches 26-30%. The mentioned technological procedure has increased durability of TBC top ceramic layer at cyclic temperature change 1135↔50°C (cycle time is 1 h) from 70 to 210-170 thermal cycles (hours) [Wortman D.J. et al. Bond coat development for thermal barrier coating. - Trans. ASME, J. Eng. for Gas Turbines & Power, - 1990, 112, 10, p.527-530].

Similar MeCrAlHf and MeCrAlHfPt coatings with a gradient across the thickness produced by the combination of EB evaporation of MeCrAl standard alloys and subsequent hafnium and platinum ion condensation or cathode spraying are described in the US Patent 4 123 595 of 31.10.78. In the US Patent 4 101 715 of 18.07.78 a method of platinum deposition on a condensed CoCrAlY coating by electroplating with the further thermal treatment in vacuum was proposed. This permitted to considerably increase corrosion resistance of high-temperature alloys having platinum distribution gradient across the thickness in the CoCrAlYPt coating top layer. Corrosion resistance of platinum-containing coatings is improved at the expense of wetting decline of Al₂O₃ film by the salt melt. The drawback of the mentioned methods of gradient corrosion-resistant coating production is high thermal conductivity and insufficient thermal stability of the protective coating at multiple thermal cycles.

In three layer metal/ceramics coating of MeCrAlY/ZrO₂-8%Y₂O₃ type to increase the top ceramic layer thermal cyclic durability an intermediate 30-40 µ m thick single-phase plastic layer is introduced between the protective substrate and the main oxidation-resistant layer. This intermediate layer provides aluminium concentration gradient across the layer thickness from 3.5-5% at the surface of protective alloy to 11-13% on the oxidation-resistant bond coat surface. This technical solution is being realized by a successive EB evaporation of various chemical composition alloys from two independent sources in the same vacuum chamber [UK Patent #2252567 of 11/02/91, German Patent #4103994 of 09.02.91, Italian Patent # 1247155 of 07.02.91].

A method of ceramic coating production is known having high adhesive strength with a substrate ( with an intermediate bond coat) with the application of EB evaporation in vacuum [US Patent # 43213111 of 23.03.82]. In this patent an application of the component annealing is considered having Ni-Co-Cr-Al-Y bond coat produced by plasma spraying in atmosphere or by vacuum-plasma spraying (APS, VPS methods), in wet hydrogen or in low vacuum and possible introduction of the oxide phase disperse particles into the intermediate metal layer to increase its thermal stability at thermal cycles. In the US Patents # 4405660 of 20.09.83 and #4414249 of 08.11.83 it was proposed to polish the NiCoCrAlY bond coat produced by VPS method and to treat it in the oxidizing atmosphere with the oxygen dosage injection to form a fine-grained 0.5-2.5 µm thick Al₂O₃ film firmly adhesive to the substrate and being a metal/ceramics transition zone before EB deposition of a ceramic 125-1250 µm thick ZrO₂-7%Y₂O₃ TBC.

With the aim to increase durability of TBC with the external ceramic layer from partially stabilized zirconia produced by EB-PVD in vacuum, the authors of US Patents # 4880614 of 14.11.89 and # 5015502 of 14.05.91 proposed to form an intermediate uniform porous-free interlayer of high purity Al₂O₃ oxide (of 1 µ m thick) by the chemical condensation methods (not disclosed). At that to obtain the structure gradient of the external thermal barrier layer it is recommended to use surface laser fusion of the ceramic coating.

The above-mentioned solutions are considerably awkward from the technological point of view, require additional equipment and long time (4-8 hours) for the production of corresponding α - Al₂O₃ barrier layers at the coating surface.

In the publication [K.J.Schmitt-Thomas et al. Thermal barrier coatings with improved oxidation resistance/ Surface & Cont. Technology. - 1994, 68/69, p.113-115] a possibility of thermal barrier layer production from 2-5 µm thick alumina by reactive sputtering in vacuum from a separate source has been considered. An oxide film is being formed on the surface of oxidation-resistant coatings of Ni-Cr, Ni-Cr-Al, MeCrAlY (Co-31Ni-21Cr-8Al-0.3Y) type produced by LPPS methods. The mentioned technical solution has provided for the increase of the bond coat scaling resistance and resistance to spallation of plasma-sprayed ceramic coatings from stabilized zirconia.

The most close in the aggregate of the features and therefore being a prototype method for protective coating production has been described in the US Patent # 4676994 of 30.06.87 Cl. B05D 3/06, C23C 11/00. In this method a protective coating with the gradient of chemical composition and structure across the thickness and the top ceramic layer is produced by the electron-beam heating of stabilized zirconia ingot placed into a water-cooled crucible till it is melted and evaporated and the vapor flow is subsequently condensed on a substrate preliminarily coated with a heat-resistant MeCrAlY bond coat having an adaptive layer on the alumina base. Thus, a gradient coating is obtained from stabilized zirconia having various grain size and ceramics density in the protective layer. Ceramic layer density (δ = 2-3 µm) adjacent to the bond intermediate layer is 96% from the theoretical one, it is reached at 0.5 µm/min deposition rate of the vapor flow of stoichometric zirconia.

The above-described method of protective coating formation with a chemical composition and structure gradient across the thickness permits to obtain two-, three- and multilayer compositional coatings having, as a rule, flat metal/metal + oxide or oxide/oxide interfaces. The difference in physical-chemical properties of the layers, and of the thermal coefficients of linear expansion(TCLE), in the first place, of the Young's modulus, as well as irreversible oxidation reactions (gas corrosion) at the interfaces during operation cause the coating premature fracture, mainly of the ceramic layer.

Elimination or restriction of the undesirable physical-chemical processes at the metal/ceramics interface can be achieved by protective coating creation with a discrete (smooth) change in composition and structure while transferring from one layer to another. Such coatings can be obtained by EB-PVD method of the multicomponent mixtures to be evaporated from one source. These mixtures contain substances with different vapor pressure at evaporation temperature. In the paper [G. Zinsmeister. The direct evaporation of alloys/ Vakuum-Technic.- 1964, No.8, p.233-237] it was shown that evaporation of the two-component melt starts always with the component evaporation having a higher vapor pressure. After that with the increase of evaporated melt quantity, the component evaporation with low vapor pressure takes place. The higher element concentration with the high vapor pressure in the evaporated mixture is, the stronger these differences are shown. As a result of the mentioned change sequence of the vapor phase composition in the evaporation and condensation process, the component concentration gradient across the coating thickness is being formed on a substrate (of the coated component). Thus, the layer, adjacent to the substrate, contains maximal component quantity with a high vapor pressure.

This phenomenon is used in the proposed method of protective coating production with a gradient of chemical composition and structure across the thickness.

A task was set forth to modernize the existing method of protective coating production on a substrate having a gradient of chemical composition and structure across the thickness and the external ceramic layer at the expense of a mixture layer of metals (alloys) and oxides with various vapor pressure at the evaporation temperature being preliminarily applied (deposited) on the top side of evaporated ceramic ingot from stabilized zirconia.

The set forth task is resolved as follows. In the proposed method of protective coating production on a substrate with a gradient of chemical composition and structure across the thickness having a top ceramic layer and a provision of EB heating of ceramic ingot from stabilized zirconia placed in a water-cooled crucible, its evaporation and further vapor flow condensation on a heated substrate in vacuum, a mixture of metals (alloys) and oxides is applied on the top side of ceramic ingot by a physical-metallurgical method; and the mentioned coating is obtained by subsequent evaporation of the above-said layer and ceramic ingot.

In particular, the layer of metals (alloys) and oxides mixture is deposited on the top side of ceramic ingot in the form of a pressed and vacuum annealed metal-ceramic pellet.

To realize condensation at more low substrate temperature without adhesion degradation, on the top side of ceramic ingot a layer of metals (alloys) and oxides mixture of Al-Al₂O₃-ZrO₂ system is deposited having the following component content (% per mass):

| | |
|---|---|
| Al - | 5-40, |
| Al₂O₃ - | 1 -60, |
| ZrO₂ - | the rest. |

To improve the substrate wettability by a condensed material, on the top side of ceramic ingot a layer of metals (alloys) and oxides mixture of Al-Si-Y-Al₂O₃-ZrO₂ system is deposited having the following component content (% per mass):

| | |
|---|---|
| Al - | 5-40, |
| Si - | 0.3-3, |
| Al₂O₃ - | 3 -84, |
| Y - | 0-1.5, |
| ZrO₂ - | the rest. |

To increase bond coat reliability, on the top side of ceramic ingot a layer of metals (alloys) and oxides mixture of Al-Cr-Ni-Al₂O₃-Y-ZrO₂ system is deposited having the following component content (% per mass):

| | |
|---|---|
| Al - | 2-18, |
| Cr - | 5-40, |
| Ni - | 0-40, |
| Al₂O₃ - | 2 -58, |
| Y - | 0-1.5, |
| ZrO₂ - | the rest. |

To increase corrosion resistance of the gradient coating, on the top side of ceramic ingot a layer of metals (alloys) and oxides mixture of Al-Cr-(Ni,Co)-Al₂O₃-Y-Pt-ZrO₂ system is deposited having the following component content (% per mass):

| | |
|---|---|
| Al - | 4-12, |
| Cr - | 10-25, |
| Ni - | 25-45, |
| Co - | 25-45, |
| Al₂O₃ - | 1 -60, |
| Y - | 0.5-2.5, |
| Pt - | 0.5-2.5 |
| ZrO₂ - | the rest. |

Application on the top side of evaporated ingot from stabilized zirconia of the mixture of metals (alloys) and oxides having various vapor pressure at evaporation temperature permits to create on a substrate multilaminate protective coatings with discrete (smooth) change of the coating composition and structure across the thickness while transferring from the substrate to the external layer. This effect is reached by fractionating of the component mixture of a definite composition in the process of its EB heating and evaporation from one crucible.

In Al-Al₂O₃-ZrO₂ system the Al primary evaporation at the first moment of the electron beam affect on the layer (pellet) has provided to realize condensation at the temperature 30-50°C lower than usual without adhesion degradation. Aluminium presence in the gradient coating internal layer compensates for Al₂O₃ partial dissociation at the initial moment of EB heating, this improves sintering of Al₂O₃ thin oxide layer which transfers smoothly over the eutectic point into zirconia layer, having high erosion resistance and heat-insulation effect even in small thicknesses (3-5 µm). Zirconia thin layer is characterized by a fine-grained structure and high fracture viscosity and has a stable chemical connection with Al₂O₃ in solid state.

When using Al-Si-Y-Al₂O₃-ZrO₂ system, small silicon additions (1-3%) improve in the first place the substrate's wettability by the condensed material, this has increased the coating adhesion on high temperature nickel alloys. The mentioned silicon quantities increase resistance to gas corrosion of the substrate-gradient coating diffusion zone, and in complex with Al₂O₃ oxide they have provided for a two-three times durability increase of the gradient condensed coating under thermal cycles at 1100-1150°C maximal environmental (gas flow) temperature.

However, silicon diffusion into protecting superalloy substrates can decrease creep resistance of the substrate-coating diffusion zone material. Therefore for stable operation at high temperature another composition of Al-Cr-Ni-Y-Al₂O₃-ZrO₂ was proposed which possesses exclusively high reliability while using as a bond coat in TBC structures, where external ceramic layer transfers into a thermal barrier one produced by a subsequent evaporation of the pellet and of ceramic ingot of partially stabilized zirconia of a standard chemical composition ZrO₂-(7-8)% Y₂O₃.

A considerable increase of the gradient coating corrosion resistance is reached by additional introduction of 0.5-2.5% platinum into the evaporated mixture (AI-(Ni Co)-Cr-Al₂O₃-Y-Pt-ZrO₂ system), especially in an atmosphere containing sodium chloride and sodium sulfite. Platinum addition has 1.5-2 times increased the gradient of coating resistance to salt corrosion, stabilizing protective functions of Al₂O₃-ZrO₂ ceramic layer and restricting diffusive mobility of separate components in the gradient structure of the condensed protective coating produced by evaporation directly from the pellet.

Vacuum evaporation of a prescribed quantity or a final weight of heat-resistant materials with different vapor pressure from one source is the most acceptable method for the gradient coating production, in particular, TBCs with top ceramic layer.

The above-proposed coating systems are canonical in the anti-corrosion protection of the items operating at high temperature in the aggressive gas flows.

The advantage of the claimed method of the coating production is as follows. During electron-beam heating of the mentioned layer and of ceramic ingot, when a definite heating temperature is reached, a subsequent evaporation of the mixture components, which form a transition gradient zone, takes place. The said evaporation transfers smoothly into evaporation of the ceramic ingot itself forming the external thermal barrier layer of the gradient coating.

Smooth gradient of chemical composition and structure of the protective layer across the thickness provides better correlation of thermal-physical characteristics (thermal coefficient of linear expansion, Young's modulus etc.) of structural components of oxidation-resistant (corrosion-resistant) or thermal barrier coating from stabilized zirconia. This permits to obtain high corrosion-and thermal-cyclic durability of the components from high temperature alloy with a protective gradient coating.

To obtain a thin (δ ≈ 5-8 µm) protective gradient coating with the external zirconia layer it is possible to evaporate from the mentioned crucible only the mentioned layer in the form of a sintered pellet of the metal (alloy) and oxide mixture having different vapor pressure at evaporation temperature. The received protective gradient coating with the external zirconia layer is characterized by high density, reliable adhesion with the protected surface and resistance to abrasive wear, low surface roughness (Rₐ < 0.5µm) of the ceramic layer.

Technical essence and operation principle of the invention is explained by the examples of realization with references to the enclosed drawings.

Fig.1 shows the distribution curves of separate components across the thickness of condensed protective coating with gradient composition and structure produced by direct evaporation of the mixture layer of 13%Al-7%Al₂O₃-79%(ZrO₂-7%Y₂O₃) placed (fixed) at the top side of ceramic ingot in the form of a sintered pellet - example 1.

Fig.2 - the same for initial coating with gradient composition and structure produced by evaporation of a sintered pellet the components of which are chosen in the proportion: 13%Al-1%Si-7%Al₂O₃-79%(ZrO₂-7%Y₂O₃) - example 2.

Fig.3 - the same for initial coating with gradient composition and structure produced by evaporation of a sintered pellet whose components are chosen in the proportion: 8%Al-25%Cr-33%Ni-3%Al₂O₃-1%Y-30%(ZrO₂-7%Y₂O₃) - example 3.

Fig.4 - the same for initial coating with gradient composition and structure produced by evaporation of a sintered pellet whose components are chosen in the proportion: 8%Al-40%Co-15%Cr-2.5%Al₂O₃-0.8%Y-1.7%Pt-32%(ZrO₂-7%Y₂O₃)- example 4.

Fig. 5 shows thermal cyclic durability of protective coatings with a gradient of chemical composition and structure across the thickness having the external ceramic layer produced by a subsequent evaporation of pellets and ceramic ingot from partially stabilized zirconia ZrO₂-7%Y₂O₃, at the top side of which pellets of different chemical composition (examples 1,2,3) are placed, at that evaporation was executed from one crucible.

Method of production on a substrate of protective coating with the chemical composition and structure gradient across the thickness and top ceramic layer consists in the following: on the top side of ceramic ingot from stabilized zirconia (ZrO₂-7%Y₂O₃) to be evaporated from the water-cooled copper crucible a mixture layer of metals (alloys) and oxides Al₂O₃ and ZrO₂ is applied (deposited) either by plasma spraying or in the form of a pressed and vacuum annealed metallic-ceramic pellet. At that the components of the mentioned applied mixture have various vapor pressure at evaporation temperature. Mass of the mixture components to be applied at the face side of ceramic ingot as a plasma-sprayed layer or a pressed pellet is chosen depending on the required coating thickness.

Before plasma deposition of the layer of the mentioned metal and oxide mixture at the top side of ceramic ingot this ingot is annealed in the muffle furnace, for example, at 650°C. For the layer deposition a plasma-arc equipment Kiev-7 is used. Ceramic ingot temperature during the mentioned mixture deposition at its top side is 150-180°C. The deposition process parameters are maintained constant: power - 32 kW, arc current - 400 A (voltage - 80 V). The distance from the nozzle cut to the top side of ceramic ingot installed in a special tooling was 80 mm. After the mixture of metals and oxides being applied at the top side of the ingot, the latter is placed into forevacuum chamber (p=1·10⁻¹ Pa) for vacuum degassing at 250-280°C, 1.5 h to remove moisture from ceramic ingot and gases from the plasma-deposited metallic-ceramic mixture and holding before its transfer into evaporator of the corresponding EB coater.

Before depositing the layer of the mentioned mixture of metals and oxides at the top side of ceramic ingot in the form of a pellet the latter is preliminarily sintered and vacuum calcinated at 580-600°C. Such temperature is chosen to provide mechanical strength of the pellet. Ceramic ingot with the layer in the form of a pellet of the mixture of metals (alloys) and alumina and zirconia deposited at its top side is also vacuum calcinated at 250-280°C, 1.5 h, to remove moisture from the ceramic ingot.

After fulfillment of the above-mentioned technological procedures ceramic ingot with coated top side (or with the pellet placed on its top side) is placed into a water-cooled copper crucible of the main (coating) chamber which is subsequently pumped out (evacuated). To fulfill subsequent operations of the method the standard electron-beam equipment is used (UE-143M, UE-137, UE-204 and other type units) having 17.5-20 kV operating voltage and beam current changing in the range from 0.1 to 2.8 A.

When residual gas pressure in the chamber reaches the value of not more than 1·10⁻⁴ Hg mm (1.13·10⁻² Pa), the electron beam is focused at the ingot placed in the crucible. Kinetic energy of electrons is transformed into a thermal one due to their deceleration by the object surface. This results in electron-beam heating of the ingot's top side which was preliminarily coated with the said mixture (or on which the pellet was placed). Thermal energy released in the volume of the mixture applied at the top side of the heated ceramic ingot is increased using a special adjustable device up to the start moment of melting and evaporation of a mixture layer (pellet) consisted of metals and oxides applied (deposited) at the top side of the said ceramic ingot.

Evaporation of the proper ZrO₂-7%Y₂O₃ ceramic ingot starts simultaneously with the end of evaporation of the mixture layer applied at the ingot top side.

By the described method using fractionating effect of definite composition component mixture in the process of its EB heating in one evaporator (crucible), the condensed coatings were obtained with the chemical composition and structure variable across the thickness. Initial coating layers, adjacent to the substrate, should be enriched with a more light volatile component, in our case of thermal resistant and thermal barrier coatings - with aluminium and chromium. In the intermediate layers of such type coatings the components with lower vapor pressure and higher melting temperature prevail, for example, silicon, alumina, ceria, yttria and platinum. At the final stage of protective coating formation, i.e. during formation of its external layers, primary evaporation and condensation of substances with maximum high melting temperature - yttria, zirconia - take place. Using at molecular level stabilized ZrO₂-7%Y₂O₃ powder as zirconia, evaporation and condensation of the vapor flow of initial composition ZrO₂-Y₂O₃ ceramics take place.

Thus, a ceramic thermal barrier layer of zirconia up to 250 µm thick is obtained on the protected surface without a sharp composition and structure gradient across the thickness.

The essence of the proposed invention is illustrated by experimental data which demonstrate formation of the coatings with a chemical composition and structure gradient across the thickness during evaporation of the metal-ceramic plasma-sprayed mixtures applied at the top side of ZrO₂-7%Y₂O₃ ceramic ingots as well as pressed and sintered metal powders, heat resistant alloys and oxides. 6-8 µm thick gradient coatings were obtained at stationary substrates by evaporation and condensation of 6-15 g pellets. The same thickness coatings with 135-150 µm top ceramic layer are produced on rotating substrates by evaporation of 30-45 g pellets and of standard ZrO₂-7%Y₂O₃ ceramic ingot (initial density 4 ± 0.1 g/cm³) as well as of ZrO₂-7%Y₂O₃ ceramic ingots with a layer of metals and alumina and zirconia plasma-sprayed at their top sides for further thermal cyclic tests of the pins.

To obtain oxidation-resistant gradient coatings, a vapor phase was condensed on the EP-99 nickel alloy substrates (see Table 1). The substrates were used either without any intermediate coating or with a Ni-22Co-18Cr-11Al-(Y) oxidation-resistant coating. The substrate temperature was 850-900°C.

During coating deposition on the substrates rotating in a vapor flow, according to the claimed method, definite requirements are produced to the quality of surface preparation of these substrates. Roughness Rₐ should not exceed 0.6 µm, 0.25-0.3 µm is more preferable, this being reached by surface treatment with standard polishing papers, abrasive strips N320, N500 or grinding discs.

**Table 1**

| **Chemical composition (% per mass) of alloys used as protecting substrates** | | | | | | | | | |
|---|---|---|---|---|---|---|---|---|---|
| Ni alloy | Ni | Cr | Co | Mo | W | Al | Ti | Fe | C |
| EP-99 | rest | 22.5 | 6 | 4.5 | 7 | 3.0 | 1.3 | 4.5 | 0.1 |
| EP-958 | rest | 18 | 5.6 | 4 | 4.1 | 4.5 | 2.6 | 2.3 | 0.15 |
| Hastelloy-X | rest | 22 | 1.5 | 9 | 0.6 | 0.5 | - | 18.5 | 0.1 |

Thermal cyclic durability of TBCs with gradient composition and structure obtained by evaporation from one source, was estimated by pin tests of high temperature alloys EP-958 and Hastelloy-X (see Table 1) in air at 1135°C maximal isothermal holding temperature; heating time of one cycle was 24 h. Pins taken out from the furnace, were cooled by an intensive air flow at 185°/min cooling rate till room temperature (within 6-10 min.). Time to rupture (number of thermal cycles) of the top ceramic layer was fixed, it corresponded to the corrosion spot or star microcrack appearance, observed by the naked eye, or to ceramics spalling from 10% of the working surface of specimens.

The character of gradient distribution of the components across the thickness defines reliability and life time of the coatings: obtained high functional characteristics of the coatings are an important indicator of the claimed method efficiency.

### Example 1 Al-Al₂O₃-ZrO₂ system

To produce protective coating with the chemical composition and structure gradient across the thickness a ceramic ingot on zirconia base (ZrO₂ - 7%Y₂O₃) with 500±20 g mass is used to be evaporated and condensed in vacuum between the vacuum heated substrate and the top ceramic layer. Its top side is plasma-arc deposited with a powder mixture containing 13% of metallic aluminium, 7% of Al₂O₃ and 80% of ZrO₂ -7%Y₂O₃ in the powder form of stabilized solid solution 3.2-3.6 mm thick, this corresponds to 30-38 g deposited layer mass. The ingot with the mentioned mixture layer deposited on its top side is placed into a vacuum furnace and is heated up to 630°C within 2 h (at the higher heating temperature local melting of the layer can occur, this being extremely undesirable). After the mentioned heat-treatment the ingot is installed into a water-cooled crucible with the deposited layer on top. After that the main chamber of the coater is pumped out (evacuated) till the residual pressure being in the limits of 1·10⁻⁴ -5·10⁻⁵ Hg mm (1.13·10⁻² - 5.65·10⁻³ Pa). Then an electron beam is focused on the top side of the ingot to heat the surface layer up to 480°C (at that beam current should not exceed 0.08-0.1 A). A special program gauge increases the power of the electron beam at constant beam raster pattern affecting the deposited mixture of metals and oxides on the ingot top side for its evaporation. Electron beam current is in the range of 1.8-2.5 A. When evaporation process of the mixture (mainly, of zirconia powder) is over, evaporation of the same chemical composition ceramic ingot starts. Within 20-25 min of the total time of evaporation and vacuum condensation process, a 140-150 µm thick coating is obtained. The coating obtained by such method is characterized by the absence of the interface in the zone which corresponds to the finish of the mixture layer evaporation and the start of ZrO₂ -7%Y₂O₃ ceramic ingot evaporation. This increases considerably resistance of such coatings to thermal impact at thermal cycles, if compared with the prototype.

### Example 2 Al-Al₂O₃-ZrO₂ system

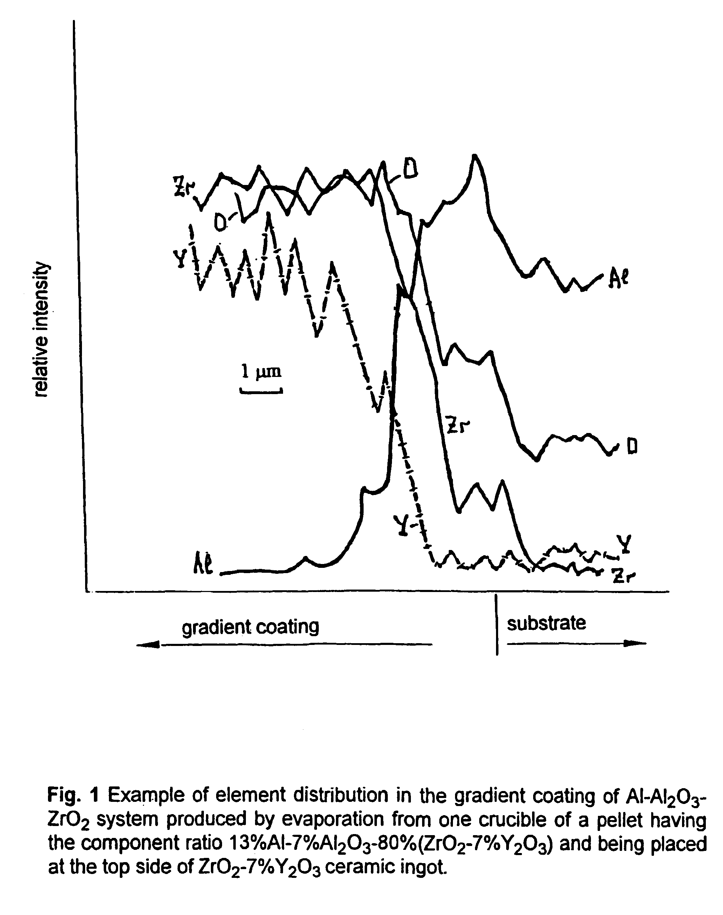

Three component mixture 13%Al-7%Al₂O₃-80%(ZrO₂-7%Y₂O₃) in the form of 6g and 28g pellets placed respectively into a water-cooled copper crucible and on the top side edge of partially stabilized zirconia ZrO₂ -7%Y₂O₃ ceramic ingot
(Ø 70 mm) also placed into a water-cooled crucible, were evaporated by the direct electron beam action. Condensation took place in the first case (6 g pellet) on a flat stationary substrate of EP-99 alloy. In the second case (28 g pellet) the vapor flow was condensed on rotating Hastelloy-X pins (Ø 10 mm). With the help of X-ray spectral microanalyser CAMEBAX a typical gradient distribution of the components across the condensed coating thickness was determined (Fig.1). Presented concentrational curves of the component distribution show smooth transition from Al to alumina and to zirconia. As should be expected, metallographic study of the coating cross-sectional microstructure with the help of scanning electron microscope CamScan did not show the existence of the flat interfaces between Al₂O₃ and ZrO₂.Y₂O₃.

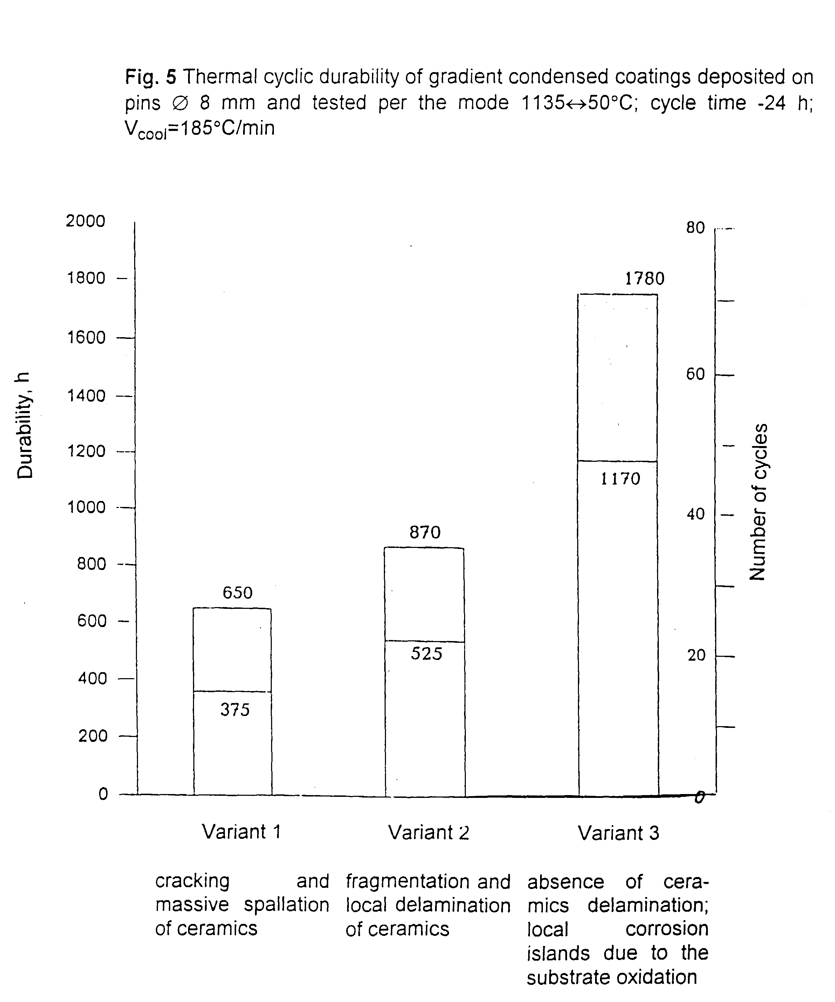

Pins with gradient coating including the external ceramic layer were subjected to thermal cyclic life time tests per the mode 1135°C↔50°C (Fig. 5).

Al-Al₂O₃-ZrO₂ gradient coating has been successfully realized at zirconia content reduction till zero values (see Table 2). Al-Al₂O₃-ZrO₂ coatings can be effectively deposited to protect titanium alloys, BT-6C, for example.

The microstructural analysis results proved complete identity of the coatings obtained in examples 1 and 2. However, in case of plasma spraying of the mixture of metals and oxides spitting of evaporated metal is more distinct at transition of the 'coated layer-ceramic ingot' boundary than at transition of 'sintered pellet-ceramic ingot' boundary.

### Example 3 Al-Si-Al₂O₃-Y-ZrO₂ system

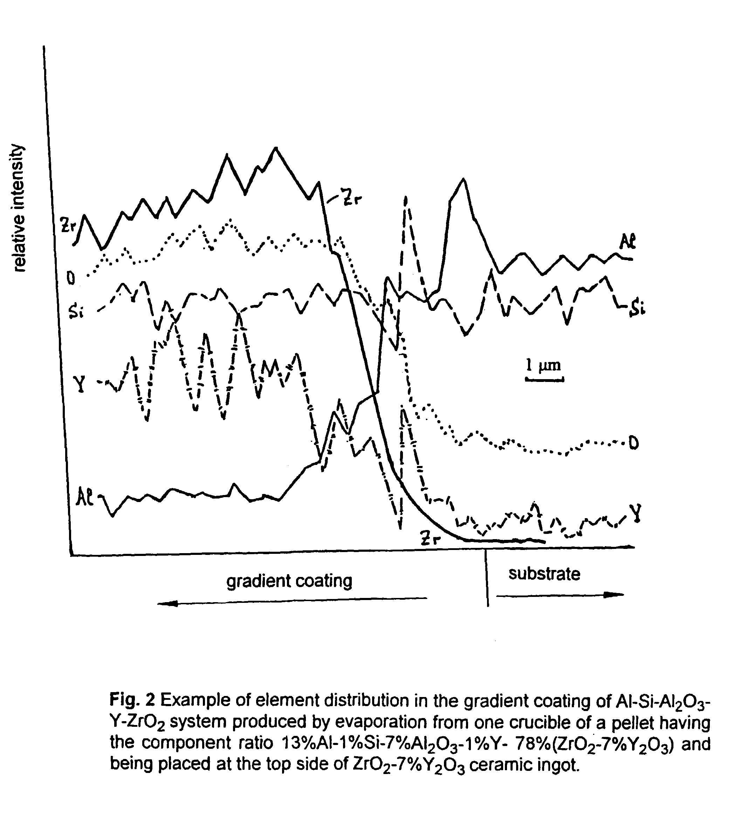

Silicon in the amount of 1-3% increases considerably gas corrosion resistance in the coatings to protect turbine blades working with contaminated fuel. The mixture of four components 13%Al-1%Si-7%Al₂O₃-79%(ZrO₂-7%Y₂O₃), same as in Example 1, in the form of 6 g and 30 g pellets was evaporated in the sequence similar to Example 1. Obtained component distribution across the thickness of condensed coating is shown in Fig.2 (in this case gradient coatings were deposited on a substrate with Ni-22Co-20Cr-11Al-(Y) bond coat). Silicon is evaporated from the pellet next to the metallic aluminium practically simultaneously with Al₂O₃.

As a result of evaporation of the pellet placed on ZrO₂ -7%Y₂O₃ ceramic ingot, there was not determined interfaces in the gradient coat; the top thermal barrier layer up to 125-130 µm thick was formed directly after zirconia evaporation from the pellet.

In this variant of gradient coating ceria can be used instead of alumina.

**Table 2**

| **Chemical composition (% per mass) of the pellets evaporated in the form of mixtures of metal powders and oxides to produce protective gradient coatings by vacuum condensation** | | | | | | | | |
|---|---|---|---|---|---|---|---|---|
| Al-Al₂O₃-ZrO₂ system | | | | | | | | |
| Variant | | Al | Al₂O₃ | | | ZrO₂ | | |
| 1.1. | | 5 | 1 | | | rest | | |
| 1.2 | | 13 | 7 | | | rest | | |
| 1.3 | | 10 | 45 | | | rest | | |
| 1.4 | | 30 | 56 | | | rest | | |
| 1.5 | | 40 | 60 | | | 0 | | |

| Al-Si-Al₂O₃-Y-ZrO₂ system | | | | | | | | |
|---|---|---|---|---|---|---|---|---|
| Variant | Al | | Si | Al₂O₃ | Y | | ZrO₂ | |
| 2.1. | 4.7 | | 0.3 | 2 | 0.8 | | rest | |
| 2.2 | 13 | | 1 | 7 | - | | rest | |
| 2.3 | 27 | | 1 | 56 | 1.2 | | rest | |
| 2.4 | 14 | | 1 | 83.5 | 1.5 | | 0 | |
| 2.5 | 17 | | 3 | 5 | - | | rest | |

| AI-Cr-Ni-Al₂O₃-Y-ZrO₂ system | | | | | | | | |
|---|---|---|---|---|---|---|---|---|
| Variant | Al | Cr | Ni | Al₂O₃ | | Y | | ZrO₂ |
| 3.1. | 2 | 40 | - | 58 | | - | | 0 |
| 3.2 | 8 | 30 | - | 45 | | 1 | | rest |
| 3.3 | 8 | 25 | 33 | 3 | | 1 | | rest |
| 3.4 | 8 | 25 | - | 4 | | 1.5 | | rest |
| 3.5 | 10 | 10 | 26 | 5 | | 1.0 | | rest |
| 3.6 | 10 | 15 | 40 | 10 | | 0.6 | | rest |
| 3.7 | 13 | 16 | 40* | 3 | | 1.2 | | rest |
| 3.8 | 18 | 5 | 38 | 2 | | 0.8 | | rest |

| AI-(Ni,Co)-Cr-Al₂O₃-Y-Pt-ZrO₂ system | | | | | | | | |
|---|---|---|---|---|---|---|---|---|
| Variant | Al | Ni/Co | | Cr | Al₂O₃ | Y | Pt | ZrO₂ |
| 4.1. | 8.5 | 25 | | 10 | - | 1 | 0.5 | rest |
| 4.2 | 5 | 30 | | 20 | 7.5 | 1.5 | 1.0 | rest |
| 4.3 | 12 | 45 | 20 | 18 | 32.5 | 1 | 1.5 | 0 |
| 4.4 | 4 | 40 | | 25 | 5 | 0.5 | 2.5 | rest |
| 4.5 | 10 | | 30 | 15 | 2 | 0.5 | 0.8 | rest |
| 4.6 | 8 | | 40 | 15 | 2.5 | 0.8 | 1.7 | rest |
| 4.7 | 5 | | 45 | 20 | 3 | 0.6 | 1.2 | rest |
| 4.8 | 8 | 30 | 35 | 20 | 5 | 1.0 | 1.0 | 0 |

| | | | | | | | | |
|---|---|---|---|---|---|---|---|---|
| *60%Ni+40%Co | | | | | | | | |

### Example 4 Al-Cr-Ni-Al₂O₃-Y-ZrO₂ system

The mixture of components containing 8%Al-25%Cr-33%Ni-3%Al₂O₃-1%Y-30%(ZrO₂-7%Y₂O₃) in the form of 15g and 45g pellets has been evaporated under direct action of an electron beam the same way as described above and has been condensed on stationary substrates.

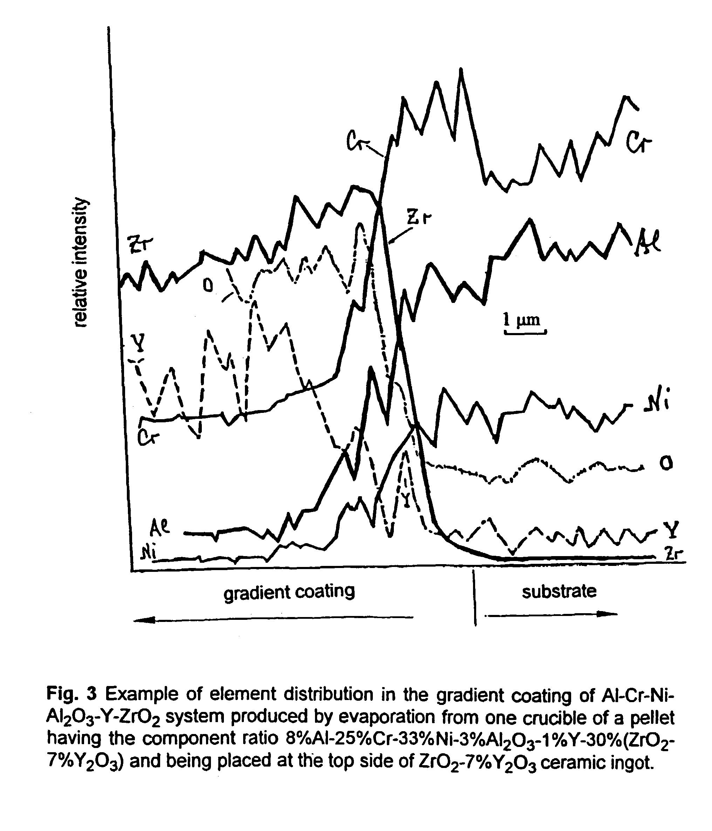

Fig. 3 shows component distribution across the thickness of the gradient coating obtained by the pellet and ZrO₂-7%Y₂O₃ ingot evaporation. A typical peak corresponding to alumina with a smooth transfer into zirconia is observed. Yttrium maximal concentration is observed in the curve's branch of zirconia concentration growth in the external layer of the gradient coating. The data in Fig. 3 confirm the absence of sharp interfaces between separate zones of the coating across the thickness.

Thermal cyclic test data of pins (Fig. 5) confirmed the possibility of such coating system practical application. In case of the pellet and ZrO₂-7%Y₂O₃ ceramic ingot evaporation from one source, when the pellet was placed at the ingot top side in one evaporator, there was not observed ceramic spalling from thermal barrier layer in the conventional form. After 1070 h tests corrosion damage centers (⌀ 2-3 mm) have appeared in the TBC.

Localized slowly progressing corrosion of the gradient coating under ceramic layer (total damaged area being not more than 5-6%) was obtained at the pin surface after ∼ 1800 h test (after that the tests were terminated).

Durability of the condensed ceramic ZrO₂-Y₂O₃ TBCs on gradient coatings produced according to the claimed method from one source are two-three times higher than durability of two layer metal/ceramics coatings produced per standard industrial technology.

### Example 5 Al-(Ni,Co)-Cr-Al₂O₃-Y-Pt-ZrO₂ system

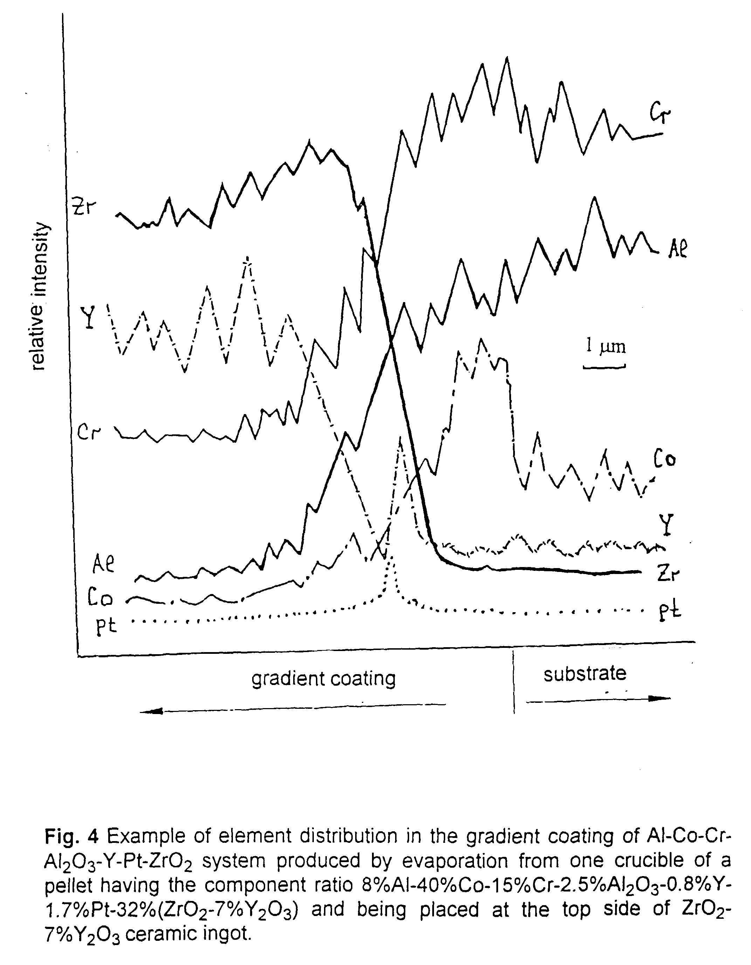

Platinum was introduced into evaporated material mixture (pellet) as a component increasing oxidation resistance of protective coatings. 15 g pellets were evaporated from a copper water-cooled crucible on a stationary substrate. Initial component mixture contained: 8%Al-40%Co-15%Cr-2.5%Al₂O₃-0.8%Y-1.7%Pt-32%(ZrO₂-7%Y₂O₃). Curves of separate element distribution in the gradient coat containing platinum were obtained by the X-ray spectral microanalysis and are shown in Fig. 4. These curves demonstrate platinum presence in the layer adjacent to ZrO₂ top layer. Such type coatings can be recommended for surface protection in oxidizing and erosion-active gas flows. Condensation of a thick ZrO₂ ceramic layer transfers these coatings into thermal barrier ones.

### Industrial applicability

The highest effect of the method's application according to the invention is shown at protective coating production on a substrate with a smooth chemical composition and structure gradient across the thickness having top ceramic layer when high quality and reliability of the protective TBC formation with the increased corrosion resistance are required under conditions of frequent thermal cycles.

## Claims

1. A method for producing on a substrate a protective coating with a chemical composition and structure gradient across the thickness, having a top ceramic layer, comprising:
heating the substrate under vacuum within a coating chamber;
electron beam heating of a ceramic ingot of stabilized zirconia placed in a water-cooled crucible for evaporating the ingot;
vapor flow condensing the evaporated ingot on the heated substrate;
**characterized** in that
an ingot is used the surface of which to be impacted by the electron beam is covered by a layer consisting of a mixture of metals (alloys) and oxides with different vapor pressure at the evaporation temperature of the ingot, the layer being first electron beam heated, evaporated and condensed on the substrate.

2. The method of claim 1, characterized in that the layer is placed on the ceramic ingot by a chemical-metallurgical process.

3. The method of claim 1, characterized in that the layer is placed on the ceramic ingot as a pressed and vacuum annealed metallic-ceramic pellet.

4. The method according to anyone of the claims 1 to 3, characterized in that on the ceramic ingot a layer of the system Al-Al₂O₃-ZrO₂ is placed.

5. The method of claim 4, characterized in that the system Al-Al₂O₃-ZrO₂ with the following component ratio (% per mass) is used:
| | |
|---|---|
| Al | - 5 to 40, |
| Al₂O₃ | - 1 to 60, |
| ZrO₂ | - the rest. |

6. The method according to anyone of the claims 1 to 3, characterized in that on the ceramic ingot a layer of the system Al-Si-Al₂O₃-Y-ZrO₂ is placed.

7. The method of claim 6, characterized in that the system Al-Si-Al₂O₃-Y-ZrO₂ with the following component ratio (% per mass) is used:
| | |
|---|---|
| Al | - 5 to 40, |
| Si | - 0.3 to 3, |
| Al₂O₃ | - 3 to 84, |
| Y | - 0 to 1.5, |
| ZrO₂ | - the rest. |

8. The method according to anyone of the claims 1 to 3, characterized in that on the ceramic ingot a layer of the system Al-Cr-Ni-Al₂O₃-Y-ZrO₂ is placed.

9. The method of claim 8, characterized in that the system Al-Cr-Ni-Al₂O₃-Y-ZrO₂ with the following component ratio (% per mass) is used:
| | |
|---|---|
| Al | - 2 to 18, |
| Cr | - 5 to 40, |
| Ni | - 0 to 40, |
| Al₂O₃ | - 2 to 58, |
| Y | - 0 to 1.5, |
| ZrO₂ | - the rest. |

10. The method according to anyone of the claims 1 to 3, characterized in that on the ceramic ingot a layer of the system Al-Cr-(Ni,Co)-Al₂O₃-Y-Pt-ZrO₂ is placed.

11. The method of claim 10, characterized in that the system Al-Cr-(Ni,Co)-Al₂O₃-Y-Pt-ZrO₂ with the following component ratio (% per mass) is used:
| | |
|---|---|
| Al | - 4 to 12, |
| Cr | - 10 to 25 |
| Ni | - 25 to 45, |
| Co | - 25 to 45, |
| Al₂O₃ | - 1 to 60, |
| Y | - 0.5 to 2.5, |
| Pt | - 0.5 to 2.5, |
| ZrO₂ | - the rest. |

## Patentansprüche

1. Verfahren zum Erzeugen einer Schutzbeschichtung auf einem Substrat, die in Dickenrichtung einen Gradienten der chemischen Zusammensetzung und der Struktur und eine obere keramische Schicht besitzt, umfassend:
Erhitzen des Substrats im Vakuum in einer Beschichtungskammer;
Erhitzen eines Keramikbarrens aus stabilisiertem Zirconiumoxid, der in einem wassergekühlten Tiegel angeordnet ist, mittels eines Elektronenstrahls, um den Barren zu verdampfen;
Kondensieren der Dampfströmung des verdampften Barrens auf dem erhitzten Substrat;
**dadurch gekennzeichnet,** daß
ein Barren verwendet wird, dessen Oberfläche, auf die der Elektronenstrahl auftreffen soll, mit einer Schicht bedeckt ist, die aus einem Gemisch aus Metallen (Legierungen) und Oxiden mit unterschiedlichem Dampfdruck bei der Verdampfungstemperatur des Barrens besteht, wobei die Schicht zuerst mittels des Elektronenstrahls erhitzt, verdampft und auf dem Substrat kondensiert wird.

2. Verfahren nach Anspruch 1, dadurch gekennzeichnet, daß die Schicht auf dem Keramikbarren mittels eines chemisch-metallurgischen Prozesses aufgebracht wird.

3. Verfahren nach Anspruch 1, dadurch gekennzeichnet, daß die Schicht auf dem Keramikbarren als gepreßtes und vakuumgeglühtes metallkeramisches Pellet aufgebracht wird.

4. Verfahren nach einem der Ansprüche 1 bis 3, dadurch gekennzeichnet, daß auf dem Keramikbarren eine Schicht des Al-Al₂O₃-ZrO₂-Systems aufgebracht wird.

5. Verfahren nach Anspruch 4, dadurch gekennzeichnet, daß das Al-Al₂O₃-ZrO₂-System mit dem folgenden Komponentenverhältnis (Masse-%) verwendet wird:
| | |
|---|---|
| Al - | 5 bis 40, |
| Al₂O₃ - | 1 bis 60, |
| ZrO₂ - | Rest. |

6. Verfahren nach einem der Ansprüche 1 bis 3, dadurch gekennzeichnet, daß auf dem Keramikbarren eine Schicht des Al-Si-Al₂O₃-Y-ZrO₂-Systems aufgebracht wird.

7. Verfahren nach Anspruch 6, dadurch gekennzeichnet, daß das Al-Si-Al₂O₃-Y-ZrO₂-System mit dem folgenden Komponentenverhältnis (Masse-%) verwendet wird:
| | |
|---|---|
| Al - | 5 bis 40, |
| Si - | 0,3 bis 3, |
| Al₂O₃ - | 3 bis 84, |
| Y - | 0 bis 1,5, |
| ZrO₂ - | Rest. |

8. Verfahren nach einem der Ansprüche 1 bis 3, dadurch gekennzeichnet, daß auf dem Keramikbarren eine Schicht des Al-Cr-Ni-Al₂O₃-Y-ZrO₂-Systems aufgebracht wird.

9. Verfahren nach Anspruch 8, dadurch gekennzeichnet, daß das Al-Cr-Ni-Al₂O₃-Y-ZrO₂-System mit dem folgenden Komponentenverhältnis (Masse-%) verwendet wird:
| | |
|---|---|
| Al - | 2 bis 18, |
| Cr - | 5 bis 40, |
| Ni - | 0 bis 40, |
| Al₂O₃ - | 2 bis 58, |
| Y - | 0 bis 1,5, |
| ZrO₂ - | Rest. |

10. Verfahren nach einem der Ansprüche 1 bis 3, dadurch gekennzeichnet, daß auf dem Keramikbarren eine Schicht des Al-Cr-(Ni,Co)-Al₂O₃-Y-Pt-ZrO₂-Systems aufgebracht wird.

11. Verfahren nach Anspruch 10, dadurch gekennzeichnet, daß das Al-Cr-(Ni,Co)-Al₂O₃-Y-Pt-ZrO₂-System mit dem folgenden Komponentenverhältnis (Masse-%) verwendet wird:
| | |
|---|---|
| Al - | 4 bis 12, |
| Cr - | 10 bis 25, |
| Ni - | 25 bis 45, |
| Co - | 25 bis 45, |
| Al₂O₃ - | 1 bis 60, |
| Y - | 0,5 bis 2,5, |
| Pt - | 0,5 bis 2,5, |
| ZrO₂ - | Rest. |

## Revendications

1. Procédé de production, sur un substrat présentant une couche supérieure en céramique, d'un revêtement de protection dont la composition chimique et la structure varient transversalement en fonction de l'épaisseur comprenant:
le chauffage du substrat sous vide à l'intérieur d'une chambre de revêtement ;
le chauffage par faisceau électronique d'un lingot de céramique à base de zirconium stabilisé placé dans un creuset refroidi à l'eau de manière à vaporiser le lingot ;
la condensation du flux de vapeur du lingot vaporisé sur le substrat chauffé ;
caractérisé en ce qu'on utilise un lingot dont la surface qui est frappée par le faisceau électronique est recouverte par une couche consistant en un mélange de métaux (alliage) et d'oxydes présentant différentes pressions de vapeur à la température de vaporisation du lingot, la couche étant d'abord chauffée par faisceau électronique, puis vaporisée et condensée sur le substrat.

2. Procédé selon la revendication 1, caractérisé en ce que la couche est déposée sur le lingot de céramique par un procédé chimico-métallurgique.

3. Procédé selon la revendication 1, caractérisé en ce que la couche est déposée sur le lingot de céramique sous forme d'une pastille métallo-céramique comprimée et soumise à un recuit sous vide.

4. Procédé selon l'une quelconque des revendications 1 à 3, caractérisé en ce que, sur le lingot de céramique, une couche du système Al-Al₂O₃-ZrO₂ est déposée.

5. Procédé selon la revendication 4, caractérisé en ce que le système Al-Al₂O₃-ZrO₂ présentant la composition suivante (% en masse) est utilisé:
| | |
|---|---|
| AI | - 5 à 40, |
| Al₂O₃ | - 1 à 60, |
| ZrO₂ | - le complément. |

6. Procédé selon l'une quelconque des revendications 1 à 3, caractérisé en ce que, sur le lingot de céramique, une couche du système Al-Si-Al₂O₃-Y-ZrO₂ est déposée.

7. Procédé selon la revendication 6, caractérisé en ce que le système Al-Si-Al₂O₃-Y-ZrO₂ présentant la composition suivante (% en masse) est utilisé:
| | |
|---|---|
| Al | - 5 à 40, |
| Si | - 0,3 à 3, |
| Al₂O₃ | - 3 à 84, |
| Y | - 0 à 1,5, |
| ZrO₂ | - le complément. |

8. Procédé selon l'une quelconque des revendications 1 à 3, caractérisé en ce que, sur le lingot de céramique, une couche du système Al-Cr-Ni-Al₂O₃-Y-ZrO₂ est déposée.

9. Procédé selon la revendication 8, caractérisé en ce que le système Al-Cr-Ni-Al₂O₃-Y- ZrO₂ présentant la composition suivante (% en masse) est utilisé:
| | |
|---|---|
| AI | - 2 à 18, |
| Cr | - 5 à 40, |
| Ni | - 0 à 40, |
| Al₂O₃ | - 2 à 58, |
| Y | - 0 à 1,5, |
| ZrO₂ | - le complément. |

10. Procédé selon l'une quelconque des revendications 1 à 3, caractérisé en ce que, sur le lingot de céramique, une couche du système Al-Cr-(Ni, Co)-Al₂O₃-Y-Pt-ZrO₂ est déposée.

11. Procédé selon la revendication 10, caractérisé en ce que le système Al-Cr-(Ni, Co)-Al₂O₃-Y-Pt-ZrO₂ présentant la composition suivante (% en masse) est utilisé:
| | |
|---|---|
| AI | - 4 à 12, |
| Cr | - 10 à 25, |
| Ni | - 25 à 45, |
| Co | - 25 à 45, |
| Al₂O₃ | - 1 à 60, |
| Y | - 0,5 à 2,5, |
| Pt | - 0,5 à 2,5, |
| ZrO₂ | - le complément. |
